Europäisches Patentamt

European Patent Office

Office européen des brevets

(11) Veröffentlichungsnummer: **0 122 499**
**B1**

(12) EUROPÄISCHE PATENTSCHRIFT

(45) Veröffentlichungstag der Patentschrift:
20.11.86

(51) Int. Cl.⁴: **H 05 K 5/02**

(21) Anmeldenummer: **84103054.7**

(22) Anmeldetag: **20.03.84**

(54) Abdeckteil für Standgehäuse, insbesondere der Datentechnik.

(30) Priorität: **22.03.83 DE 8308523 U**

(43) Veröffentlichungstag der Anmeldung:
**24.10.84 Patentblatt 84/43**

(45) Bekanntmachung des Hinweises auf die Patenterteilung:
**20.11.86 Patentblatt 86/47**

(84) Benannte Vertragsstaaten:
**AT BE DE FR GB IT NL SE**

(56) Entgegenhaltungen:
**DE - A - 1 940 874**
**DE - B - 1 099 001**
**DE - U - 8 308 523**
**US - A - 1 806 610**
**US - A - 3 506 322**

(73) Patentinhaber: **Siemens Aktiengesellschaft Berlin und München, Wittelsbacherplatz 2, D-8000 München 2 (DE)**

(72) Erfinder: **Voigt, Ulrich, Dipl.-Ing., Unertlstrasse 31, D-8000 München 40 (DE)**
Erfinder: **Hör, Leopold, Keplerstrasse 16, D-8900 Augsburg (DE)**
Erfinder: **Stöbrich, Werner, Albertusstrasse 66, D-8901 Biberbach (DE)**

## Beschreibung

Die Erfindung betrifft ein flächig ausgebildetes, an drei seiner Ränder mit Abkantungen versehenes Abdeckteil für Standgehäuse mit Vierkanthohlrohrgerüsten.

In der Datentechnik werden zur Aufnahme der elektrischen Baueinheiten Standgehäuse verwendet, die aus einem Vierkanthohlrohrgerüst bestehen, das rundum mit Abdeckteilen versehen ist, wobei insbesondere die beiden Seitenteile gleich ausgebildet sind.

Aufgabe der Erfindung ist es, die seitlichen Abdeckungen von Geräten, insbesondere für die Datenfernverarbeitung mit Verkleidungselementen zu versehen, die die Funktionen wie HF-Schirmung und Verkleidung gleichzeitig übernehmen.

Zur Lösung dieser Aufgabe wird gemäss der Erfindung das Abdeckteil derart ausgebildet, dass seine Vorderseite, die den vierten Rand bildet, gerundet und am gerundeten Ende mit einer Abkantung versehen ist, die die abgewinkelten Teile einer Frontplatte umgreift und dass an der rückseitigen Abkantung des Abdeckteils Befestigungsmittel anbringbar sind. Dadurch erhält man ein sehr einfach herzustellendes Seitenteil mit geringen Herstellungskosten.

In weiterer Ausgestaltung kann das Abdeckteil auch derart ausgebildet sein, dass die untere und obere Seite im Abstand eines Vierkanthohlrohraussendurchmessers abgekantet, mehrfach geschlitzt und leicht vorgespannt ist. Zur besseren Kontaktierung können die abgewinkelten Teile der Frontplatte mit Prägewarzen versehen sein.

Ein derartig ausgebildetes Seitenteil ist vor allem für höhere Ansprüche bei der HF-Schirmung geeignet.

Anhand der Ausführungsbeispiele nach den Figuren 1 bis 3 wird die Erfindung näher erläutert.

Es zeigen:

Fig. 1 eine perspektivische Darstellung eines Hohlrohrrahmengerüstes, bei dem auf einer Seite das Seitenteil aufgebracht und auf der anderen Seite abgenommen ist,

Fig. 2 einen Schnitt der Fig. 1,

Fig. 3 eine Einzelheit A bei Fig. 1.

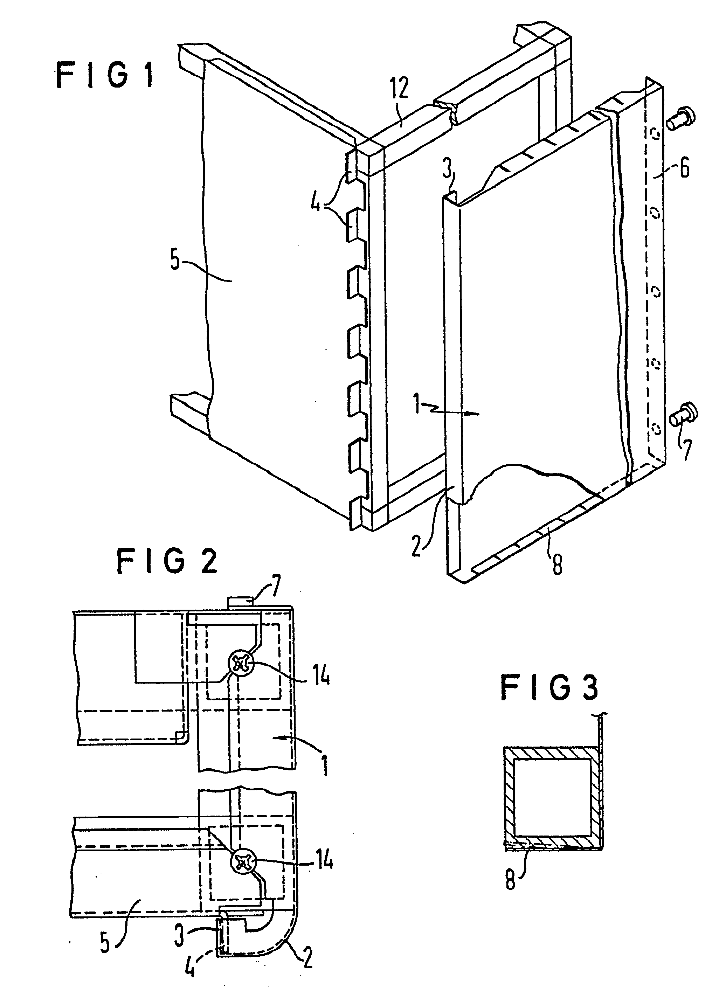

In Fig. 1 ist ein Hohlrohrrahmengerüst, das der Kernbestandteil für ein Standgehäuse ist, wie es für Einrichtungen der Datenverarbeitung verwendet wird, dargestellt. Das Gerüst besteht aus verklebten oder verschraubten Vierkanthohlrohren 12. An den beiden Kanten sind spiegelbildlich gleiche Abdeckteile 1 angebracht, während die Vorder- und Rückseite mit unterschiedlichen Abdeckteilen versehen ist. Die vorderseitige Abdeckung ist der Einfachheit halber weggelassen. Sie besteht im wesentlichen aus einer Montageplatte und einer darüber befindlichen Abdeckung. Ebenfalls ist die rückseitige Abdeckung nicht gezeichnet.

Die Montageplatte 5 an der Vorderseite ist an den beiden Vertikalseiten mit rechtwinklig abgewinkelten Platten 4 versehen, in die die vorderseitigen Abwinklungen 3 der Seitenteile eingehängt werden. Die Seitenteile werden, nachdem die vordere Abkantung federnd eingehängt ist, über die Holme geschoben und an der hinteren Abkantung mit Hilfe der Schrauben 7 angeschraubt.

Die Abdeckteile sind dabei auf drei Seiten mit Abkantungen versehen, wobei die Vorderseite gerundet ist und am Ende der Rundung eine weitere Abkantung vorgenommen ist.

An der Ober- und Unterseite des Abdeckteils ist die Abkantung im Abstand des Aussendurchmessers eines Vierkanthohlrohres 12 ausgeführt, wobei diese Abkantung 8 jeweils geschlitzt ist, so dass eine federnde Wirkung entsteht. Die geschlitzten Teile sind leicht vorgespannt, wie dies in Fig. 3 dargestellt ist. Diese federnde Abkantung, die nicht nur auf eine Seite beschränkt zu bleiben braucht, bewirkt ein FHdichtes Abschliessen, so dass auch höhere Schirmanforderungen mit dieser Konstruktion erfüllt werden können.

Fig. 2 zeigt in Draufsicht einen Schnitt der Fig. 1. Dabei erkennt man die vordere Montageplatte 5 mit den abgewinkelten Platten 4, in die das Seitenteil 1 mit seiner vorderen Abkantung 3 eingehängt ist. Die vordere Kante 2 ist dabei gerundet. Sowohl die Montageplatte an der Vorderseite als auch das Seitenteil werden von oben her mit Schrauben 14 befestigt, während die Seitenteile mit weiteren Schrauben 7 gehalten werden.

Mit der Neuerung wird erreicht, dass die fertigungsüblichen Gehäuse bzw. Gehäusetoleranzen aufgefangen werden.

Das Standgehäuse ist zwar in einer Ausführung mit geschlossenem Hohlrohrvierkantrahmen beschrieben, es kann aber auch aus offenen Profilen und auch in selbsttragender Ausführung aus Metall oder Kunststoff gefertigt sein.

## Patentansprüche

1. Flächig ausgebildetes, an drei seiner Ränder mit Abkantungen versehenes Abdeckteil für Standgehäuse mit Vierkanthohlrohrgerüsten, dadurch gekennzeichnet, dass seine Vorderseite (2), die den vierten Rand bildet, gerundet und am gerundeten Ende mit einer Abkantung (3) versehen ist, die die abgewinkelten Teile (4) einer Frontplatte (5) umgreift und dass an der rückseitigen Abkantung (6) des Abdeckteils Befestigungsmittel (7) anbringbar sind.

2. Flächig ausgebildetes, an drei seiner Ränder mit Abkantungen versehenes Abdeckteil für Standgehäuse mit Vierkanthohlrohrgerüsten nach Anspruch 1, dadurch gekennzeichnet, dass beide Seiten (8) im Abstand eines Vierkanthohlrohraussendurchmessers, abgekantet, mehrfach geschlitzt und leicht vorgespannt sind.

3. Flächig ausgebildetes, an drei seiner Ränder mit Abkantungen versehenes Abdeckteil für Standgehäuse mit Vierkanthohlrohrgerüsten nach einem der vorhergehenden Ansprüche, dadurch gekennzeichnet, dass die abgewinkelten Teile (4) der Frontplatte (5) mit Prägewarzen versehen sind.

## Claims

1. A planar cover panel, which is provided with flanges on three of its edges and serves for an upright housing with square hollow tube frames, characterised in that its front side (2) which is formed by the fourth edge is rounded and provided with a flange (3) at the rounded end, which flange embraces the bent members (4) of a front plate (5), and that fastening means (7) can be fixed to the rear flange (6) of the cover panel.

2. A planar cover panel which is provided with flanges on three of its edges and serves for an upright housing with square hollow tube frames as claimed in Claim 1, characterised in that both edges (8) are formed with multiply-slotted and slightly prestressed flanges spaced by the distance between the outer sides of its square hollow tube.

3. A planar cover panel which is provided with flanges on three of its edges and serves for an upright housing with square hollow tube frames as claimed in one of the preceding Claims, characterised in that the bent members (4) of the front plate (5) are provided with embossed projections.

**Revendications**

1. Elément de recouvrement de surface étendue, muni de rabats sur ses trois bords, pour boîtier vertical comportant des structures formées de tube creux de section carrée, caractérisé par le fait que la face avant (2), qui constitue le quatrième bord, est arrondie et est munie, sur son extrémité arrondie, d'un rabat (3) qui s'engage autour des parties coudées (4), d'une plaque avant (5) et que des moyens de fixation (7) peuvent être montés sur le rabat arrière (6) de l'élément de recouvrement.

2. Elément de recouvrement de surface étendue, muni de rabats sur ses trois bords, pour boîtier vertical comportant des structures formées de tube creux de section carrée selon la revendication 1, caractérisé par le fait que les deux côtés (8), qui sont repliés à une distance correspondant au diamètre extérieur du tube creux de section carrée, comportent plusieurs fentes et sont légèrement précontraints.

3. Elément de recouvrement de surface étendue, muni de rabats sur ses trois bords, pour boîtier vertical comportant des structures formées de tube creux de section carrée suivant l'une des revendications précédentes, caractérisé par le fait que les parties coudées (4) de la plaque avant (5) sont munies de parties estampées en forme de boutons.

FIG 1

FIG 2

FIG 3